# EUROPEAN PATENT APPLICATION

(11) **EP 4 571 249 A1**
(43) Date of publication of application: **18.06.2025**
(21) Application number: 24216776.5
(22) Date of filing: 02.12.2024
(51) Int. Cl.: G01C 19/5628, B81C 1/00, G01C 19/5663, G01C 19/5769, G01C 19/5783

(54) **MANUFACTURING PROCESS FOR MICROELECTROMECHANICAL DEVICES HAVING IMPROVED SEALING PERFORMANCE**

(30) Priority: 15.12.2023 IT 202300026838
(71) Applicant: STMicroelectronics International N.V., 1228 Plan-les-Ouates, Geneva (CH)
(72) Inventor: ALLEGATO, Giorgio, 20900 MONZA (IT); CORSO, Lorenzo, 20871 RUGINELLO (MB) (IT); GARAVAGLIA, Matteo, 20013 MAGENTA (MI) (IT); VERCESI, Federico, 20134 MILANO (IT); AZPEITIA URQUIA, Mikel, 20128 MILANO (IT)
(74) Representative: Studio Torta S.p.A.

(57) **Abstract**

A manufacturing process for microelectromechanical devices includes: on a first wafer (1) forming a structural layer (5) and a stop layer (7); defining a stop pad (7c) from the stop layer (7); forming a first microelectromechanical structure (9a) and a second microelectromechanical structure (9b) in the structural layer (5); forming a contact element (11c) protruding from a second wafer (10); sealing, at a first pressure (P₁), the first microelectromechanical structure (9a) in a first chamber (15a) and the second microelectromechanical structure (9b) and the stop pad (7c) in a second chamber (15b); fluidically coupling the second chamber (15b) to an external environment; and sealing the second chamber (15b) at a second pressure (P₂). Sealing at the first pressure (P₁) comprises bonding the second wafer (10) to the first wafer (1) so that the contact element (11c) rests on the stop pad (7c). Fluidically coupling comprises defining fluidic passages (8) at an interface between the contact element (11c) and the stop pad (7c) and opening an access hole (13) through the second wafer (10) in communication with the fluidic passages (8).

## Description

### Technical Field

The present invention relates to a manufacturing process for microelectromechanical devices having improved sealing performance.

### Background

As is known, different microelectromechanical devices incorporated and sealed in a same package are used in many applications. For example, it is very common to integrate uniaxial or multiaxial gyroscopes and accelerometers into the same chip and therefore into the same package.

A frequent issue is linked to the fact that the devices may have optimal operating conditions very different from each other, as in the case of gyroscopes and accelerometers. In fact, in order to reduce consumption due to air friction damping, it is preferable to have the gyroscopes operate in an environment having rather low pressure, typically comprised between 0.1mbar and 1mbar. The gyroscopes are maintained constantly oscillating in resonance and low-pressure conditions allow the maintenance of the oscillations, reducing damping and dissipated energy. Accelerometers, on the other hand, normally operate under higher pressure conditions, for example comprised between 1mbar and a few atmospheres. Similar issues may also arise with other types of devices operating under different conditions, for example resonators or wake-up systems in combination with gyroscopes or accelerometers.

A possible solution consists in including different devices in a same cavity or chamber of the package, wherein a pressure level corresponding to a compromise between the preferred operating pressures is present. Solutions of this type are relatively simple to implement but may be unsatisfactory and affect performance.

According to a different solution, the microelectromechanical devices are included in respective sealed and non-communicating chambers. In practice, the devices, for example gyroscopes and accelerometers, are manufactured in a first wafer, while, in a second wafer, caps are provided, and cavities are formed in positions corresponding to respective devices. In the cavities intended for devices operating at lower pressure, a layer of an absorbent material or getter is also deposited. When the second wafer is bonded to the first wafer, for example by glass frit bonding or other wafer bonding technique, or at a later time with a dedicated step, the getter is thermally activated in order to absorb the non-noble gases present in the chamber, reducing pressure. In this manner chambers sealed with different pressures and the respective devices may operate under preferred pressure conditions.

However, even this last solution is not free from limitations. Firstly, especially when particularly high pressures are desired in one of the chambers, the amount of available gaseous nitrogen may saturate the getter and, in this case, the pressure target in the chamber may not be achieved. On the other hand, in order to include a sufficient quantity of getter to prevent saturation, the dimensions (base area and/or height) of the chamber may be greater than what would be sufficient for the sole microelectromechanical devices.

Furthermore, during manufacturing the getter may be activated prematurely during the wafer bonding steps, before the chambers are completely sealed. In this case, the getter may also absorb gas from higher-pressure chambers (cross-talk), creating a double drawback. On the one hand, in fact, the pressures of the getter-free chambers decrease and, in any case, the final pressure values are not accurately predictable. On the other hand, the getter may more easily saturate and therefore even in the low-pressure chamber the atmosphere may not reach the desired level.

### Summary

It is therefore an aim of the present invention to overcome or at least in part mitigate the disadvantages and limitations of the state of the art.

According to the present invention, a manufacturing process for microelectromechanical devices as defined in the attached claims is provided.

### Brief Description of the Figures

For a better understanding of the present invention, preferred embodiments are provided, by way of non-limiting example, with reference to the attached drawings, wherein:
- Figures 1, 3a, 4, 5a, 6a, 7a, 8 schematically show, in a same cross-section, consecutive processing steps of a manufacturing process of a MEMS device, in accordance with an embodiment of the present invention;
- Figures 2a and 3b schematically show, in a top-plan view, consecutive processing steps of a manufacturing process of a MEMS device, in accordance with an embodiment of the present invention;
- Figures 2b, 3c, 5c, 6c, 7c, schematically show, in a same cross-section, an enlarged portion of a MEMS device in consecutive processing steps of a manufacturing process in accordance with an embodiment of the present invention;
- Figures 2c, 3d, 5d, 6d, 7d, schematically show, in a same cross-section, a different enlarged portion of a MEMS device in consecutive processing steps of a manufacturing process in accordance with an embodiment of the present invention;
- Figures 5b, 6b, 7b schematically show, in a top-plan view, an enlarged portion of a MEMS device in consecutive processing steps of a manufacturing process in accordance with an embodiment of the present invention;
- Figures 9a, 9c, 9e schematically show, in a same cross-section, an enlarged portion of a MEMS device in consecutive processing steps of a manufacturing process in accordance with a different embodiment of the present invention;
- Figures 9b, 9d, 9f schematically show, in a same cross-section, a different enlarged portion of a MEMS device in consecutive processing steps of a manufacturing process in accordance with a different embodiment of the present invention;
- Figure 10a schematically shows, in a top-plan view, a MEMS device in a processing step of a manufacturing process in accordance with another embodiment of the present invention;
- Figures 10b and 10b1 schematically show, in top-plan views opposite to each other, an enlarged portion of Figure 10a;
- Figures 10c, 10e, 10g schematically show, in a same cross-section, an enlarged portion of a MEMS device in consecutive processing steps of a manufacturing process in accordance with another embodiment of the present invention; and
- Figures 10d, 10f, 10h schematically show, in a same cross-section, a different enlarged portion of a MEMS device in consecutive processing steps of a manufacturing process in accordance with another embodiment of the present invention.

### Description of Embodiments

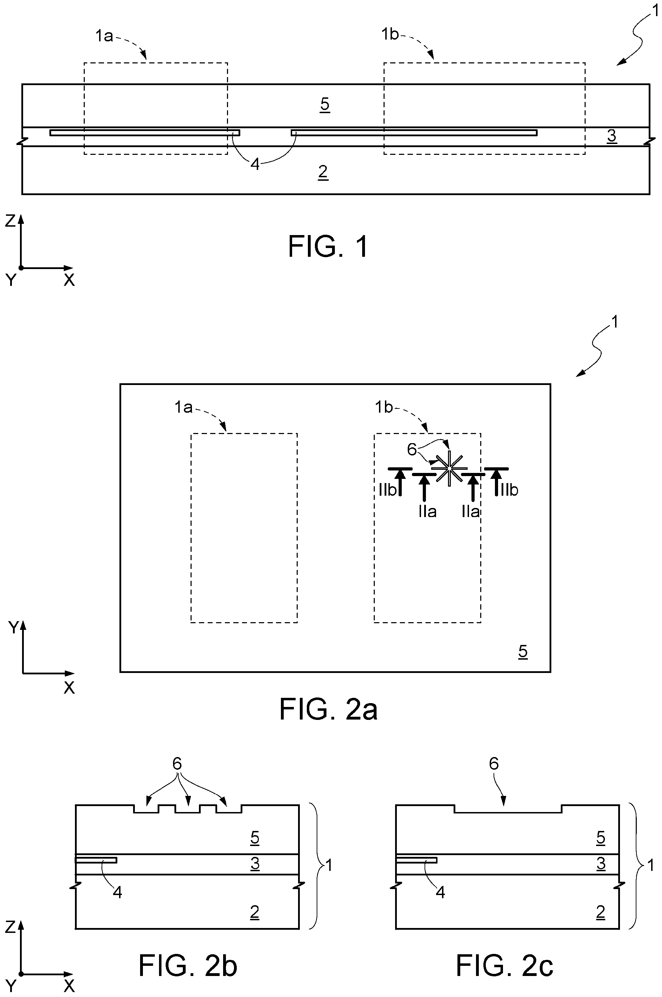

A semiconductor wafer, or simply "wafer", 1, shown in a cross-section in Figure 1, comprises a substrate 2, for example of monocrystalline silicon. A first region of the wafer 1, indicated by 1a, is intended to accommodate a first microelectromechanical sensor operating at a first pressure P₁, for example an accelerometer, and a second region of the wafer 1, indicated by 1b, is intended to accommodate a second microelectromechanical sensor operating at a second pressure P₂, lower than the first pressure, for example a gyroscope. However, it is understood that other microelectromechanical devices that require different operating pressures may be integrated into the wafer 1, such as, but not limited to, resonators, wake-up systems, geophones, bolometers.

Considering a reference system of orthogonal axes X, Y, Z, the wafer 1 has a substantially planar shape parallel to the XY plane and comprises layers of semiconductor material, as explained hereinbelow, stacked in the direction of the Z axis.

Initially, a dielectric layer 3 of silicon oxide is deposited on the substrate 2. Conductive tracks 4, for example of suitably doped polycrystalline silicon, are formed in the dielectric layer 3: the conductive tracks 4 may comprise, for example, fixed electrodes and/or buried electrical connections of respective sensors. Subsequently, a structural layer 5, for example of polycrystalline silicon, is formed on the dielectric layer 3: for example, the structural layer 5 is grown using an epitaxial reactor.

Referring to Figures 2a-2c, the structural layer 5 is subsequently processed in order to create grooves 6, for example by an anisotropic etching. The grooves 6 are organized in groups and each group forms a pattern in the structural layer 5. In a non-limiting embodiment only one group of grooves 6 is present (see Figure 2a) arranged radially. In practice, the grooves 6 are material removals in the structural layer 5, with a depth, along the Z axis, for example comprised between 0.1µm and 0.5pm. The grooves 6 are formed in the structural layer 5 in portions of the second region 1b of the wafer 1, for the reasons explained hereinbelow, for example in a lateral portion of the second region 1b.

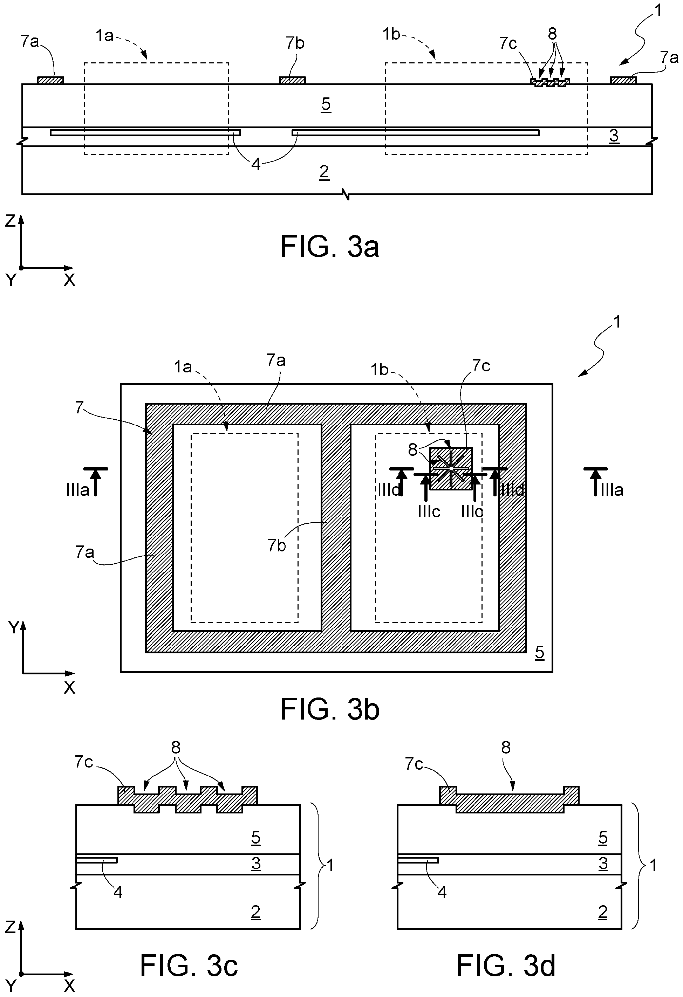

Subsequently, a stop layer 7 is deposited on the structural layer 5 with a thickness for example comprised between 0.2µm and 1µm, preferably 0.7µm. The stop layer 7 is generally of a material with respect to which the structural layer 5 and, more particularly, silicon, is selectively etchable. In a non-limiting embodiment, the stop layer 7 is of aluminum; or again, the stop layer 7 is a titanium-tungsten (TiW) compound. The stop layer 7 is subsequently patterned (for example lithographically) forming a frame portion 7a, a separation portion 7b and a stop pad 7c. In detail, with reference to Figures 3a and 3b, the frame portion 7a surrounds the first and the second regions 1a, 1b of the wafer 1, while the separation portion 7b divides the first region 1a from the second region 1b. The frame portion 7a and the separation portion 7b are for example in structural continuity.

The stop pad 7c of the stop layer 7 is formed at least in part on the respective group of grooves 6. In particular, with reference to Figures 3c (enlargement of the same section of Figure 3a) and 3d, the stop pad 7c fills the grooves 6, acquiring by transfer the pattern of the grooves 6 previously defined. The stop layer 7 therefore remains conformal to the profile of the structural layer 5, in particular replicating its pattern in the stop pad 7c. The stop pad 7c therefore defines channels 8 as a first approximation corresponding to respective grooves 6 of the structural layer 5; furthermore, the channels 8 overlie, along the Z axis, respective grooves 6 by a distance as a first approximation equal to the thickness of the stop layer 7.

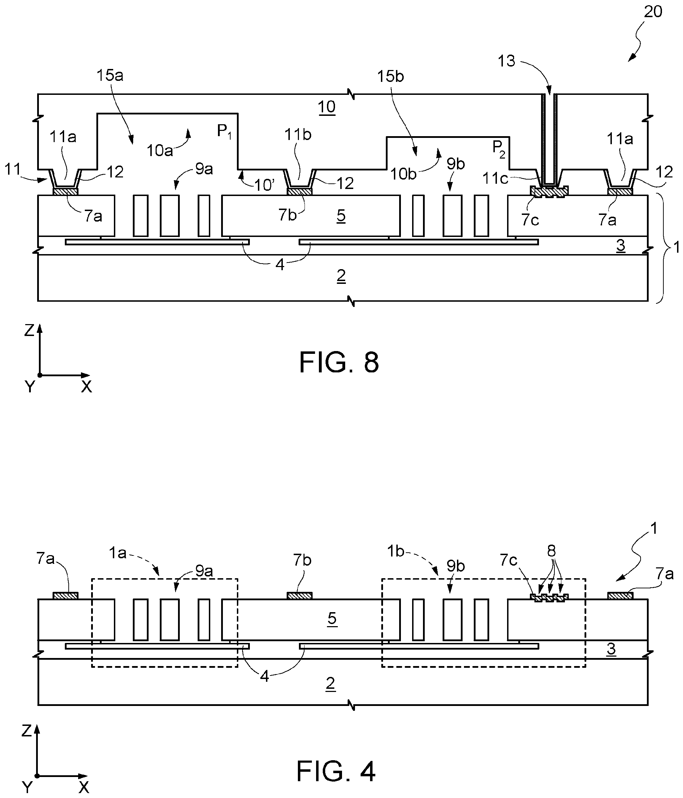

With reference to Figure 4, the structural layer 5 is subsequently processed, for example by one or more anisotropic etchings, so as to define a first microelectromechanical structure 9a of the first sensor and a second microelectromechanical structure 9b of the second sensor respectively in the first and second regions 1a, 1b of the wafer 1. For example, structures that are suspended and movable with respect to the substrate 2, and respective flexures, may be defined, opening the structural layer 5 and removing portions of the underlying dielectric layer 3.

A cap wafer 10 of semiconductor material, for example of monocrystalline or polycrystalline silicon, is separately prepared and processed on an internal face 10' arranged facing the semiconductor wafer 1 in the final device. In particular, contact elements 11, a first cavity 10a and a second cavity 10b are formed on the internal face 10'. The cap wafer 10 is shaped so as to include, once bonded to the semiconductor wafer 1, the first and the second sensors in respective chambers. In detail, the contact elements 11 are protrusions of the cap wafer 10 and are configured to allow the bonding between the cap wafer 10 and the semiconductor wafer 1, as described hereinbelow; the first and the second cavities 10a, 10b are recesses of the cap wafer 10 and are formed in positions corresponding to the respective first and second regions 1a, 1b of the wafer 1 to allow the operation of the first and the second sensors according to design specifications.

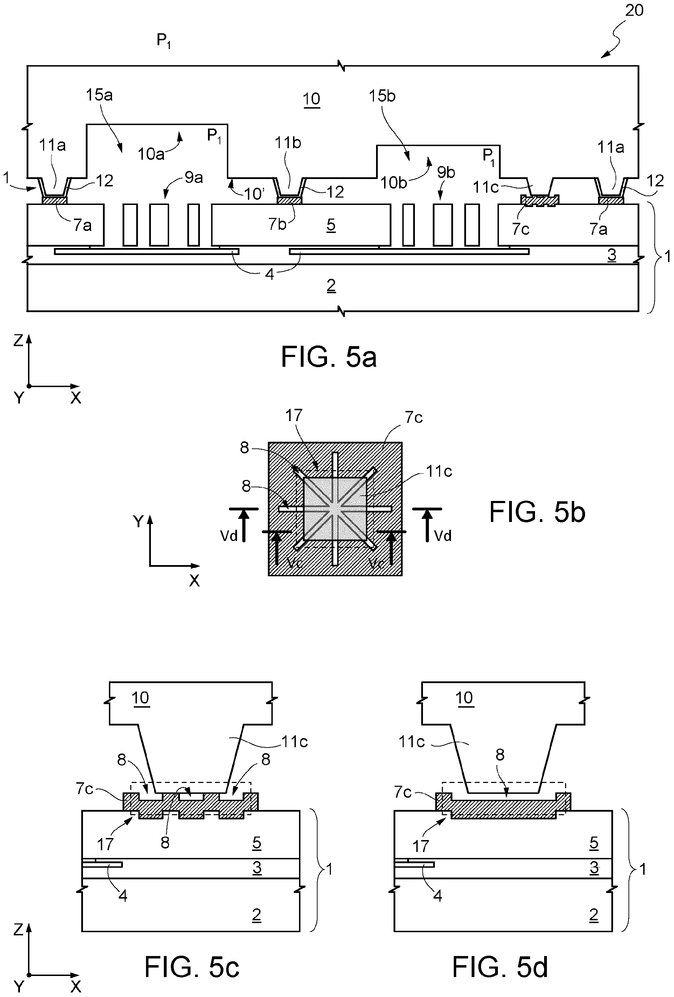

Referring to Figure 5a, the cap wafer 10 is bonded to the semiconductor wafer 1 (step known as "wafer-to-wafer bonding"); reference is made to this bonding as composite wafer 20 and it is understood that it is performed along the direction of the Z axis (the composite wafer 20 is shown in a same cross-section as Figures 1, 3a and 4). In one embodiment, the cap wafer 10 is bonded to the wafer 1 by a bonding layer 12, for example a germanium-aluminum (AlGe) compound and using for example a thermal bonding process. Alternative compounds for the bonding layer 12 may be: gold-germanium (Au-Ge); gold-indium (Au-In); gold-silicon (Au-Si); gold-tin (Au-Sn); copper-tin (Cu-Sn).

In detail, the contact elements 11 are formed on the cap wafer 10 in positions corresponding to the previously defined portions of the stop layer 7 of the wafer 1. Reference is made, in particular: to a first contact element 11a, defined starting from the cap wafer 10 so as to bond to the frame portion 7a; and to a second contact element 11b, defined so as to bond to the separation portion 7b. The first and the second contact elements 11a, 11b extend along the entire dimension, parallel to the XY plane, of the frame portion 7a and the separation portion 7b respectively (for example, the first contact element 11a extends in planes parallel to the XY plane forming a frame). Furthermore, reference is made to a third contact element 11c, defined starting from the cap wafer 10 so as to contact the stop pad 7c.

The bonding layer 12 is applied to the cap wafer 10 and defined so as to externally coat the first and the second contact elements 11a, 11b. The bonding layer 12, during the bonding process used, allows the bonding between the material of the cap wafer 10 and the material of the stop layer 7. In a non-limiting embodiment, the contact elements 11 have in section (planes parallel to the XZ plane) a substantially trapezoidal shape and extend, along the X axis, with a minimum dimension that is lower than or equal to the respective dimensions of the defined portions of the stop layer 7. In particular, the third contact element 11c has, for example, a substantially rectangular section when viewed in planes parallel to the XY plane (i.e., three-dimensionally it is, as a first approximation, a truncated pyramid).

Referring again to Figure 5a, the composite wafer 20 comprises a first chamber 15a and a second chamber 15b arranged in positions substantially corresponding respectively to the first and the second regions 1a, 1b of the wafer 1. The first and the second chambers 15a, 15b are delimited at the top by the cap wafer 10 and at the bottom by the wafer 1, they are surrounded by the first contact element 11a and are separated from each other by the second contact element 11b and by the separation portion 7b. The first and the second chambers 15a, 15b therefore respectively comprise the first and the second microelectromechanical sensors.

The bonding process of the cap wafer 10 to the wafer 1 is performed in an atmosphere at the first pressure P₁ and causes the hermetic closure of the first chamber 15a with respect to the environment external to the composite wafer 20. The first chamber 15a is therefore sealed at and maintains the first pressure P₁; consequently, the first sensor of the final device operates at the first pressure P₁. The first pressure P₁ is for example comprised between 1mbar and a few atmospheres (atm) . The bonding of the cap wafer 10 to the wafer 1 causes in practice the hermetic closure with respect to the external environment also of the second chamber 15b: the latter, however, undergoes further processes as described hereinbelow. The second contact element 11b of the cap wafer 10 ensures a hermetic separation between the first chamber 15a and the second chamber 15b, so that the subsequent processes performed on the second chamber 15b do not affect the pressure condition created in the first chamber 15a (i.e. the cross-talk between the chambers is cancelled).

In Figures 5b-5d it is possible to observe what happens in the bonding process of the cap wafer 10 to the wafer 1 in positions corresponding to the stop pad 7c and to the third contact element 11c (in Figure 5b the stop pad 7c and the channels 8 are shown enlarged and portions have been removed for clarity of understanding). The third contact element 11c comes to directly contact the stop pad 7c, where the channels 8 are absent; furthermore, the third contact element 11c at least partially overlies the channels 8. More in detail, the third contact element 11c is defined starting from the cap wafer 10 so as to extend, parallel to the XY plane, for a smaller dimension with respect to the two-dimensional pattern defined by the channels 8. In this manner, ends of the channels 8 protrude laterally with respect to the third contact element 11c and remain at least partially in communication with the second chamber 15b.

Reference is made to the overlap region of the third contact element 11c on the stop pad 7c as an exchange region 17. The exchange region 17 is a volume that comprises interface portions of the stop pad 7c and interface portions of the third contact element 11c (see in particular Figures 5c and 5d). The exchange region 17 therefore comprises the channels 8 of the stop pad 7c overlaid by the third contact element 11c.

Known intermediate grinding and trimming processes of the composite wafer 20 and, in particular, of the external surface of the cap wafer 10, follow.

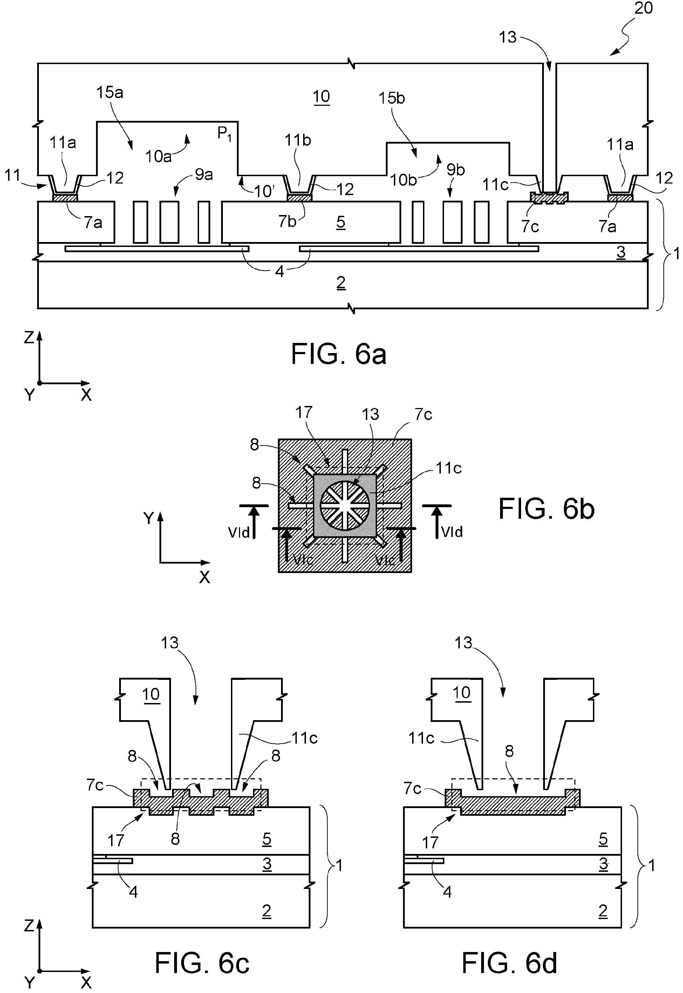

With reference now to Figures 6a-6d, an access hole (also known as a chimney) 13 is provided through the entire cap wafer 10, in a position corresponding to the third contact element 11c, and therefore to the stop pad 7c. After providing the access hole 13, the third contact element 11c remains internally hollow: parallel to the XY plane, the access hole 13 has a smaller dimension than the dimension of the third contact element 11c. The access hole 13 therefore communicates with the second chamber 15b through the channels 8.

The access hole 13 may for example be provided by a selective etching of the cap wafer 10. The etching, due to the presence of the stop pad 7c, stops at the interface between the third contact element 11c and the stop pad 7c without affecting the structural layer 5: the selectivity of the etching of the material of the structural layer 5 and of the cap wafer 10 (silicon) with respect to the material of the stop layer 7 (aluminum) allows in fact the definition of the access hole 13 to be accurately controlled. In a non-limiting embodiment, the access hole 13 has a circular section (see Figure 6b) and has for example a diameter comprised between 20pm and 30µm.

The access hole 13 is a through hole of the cap wafer 10 and puts the second chamber 15b in communication with the environment external to the composite wafer 20, through the exchange region 17. In detail, the channels 8 of the stop pad 7c form fluidic passages that allow a fluidic exchange between the inside of the second chamber 15b, initially at the first pressure P₁ following the bonding process between the cap wafer 10 and the wafer 1, and the external environment. The access hole 13 may be used, for example, to remove from the second chamber 15b (intended to comprise the second sensor, which requires for example more stringent and controlled operating conditions, such as a gyroscope) species degassed from the structural layer 5 during the bonding process.

The composite wafer 20 of Figures 6a-6d is then placed in a controlled atmosphere at the second pressure P₂. Through the access hole 13 and through the exchange region 17, the second chamber 15b reaches the second pressure P₂ preset for the operation of the respective second sensor. The second pressure P₂ is for example comprised between 0.1mbar and 1mbar.

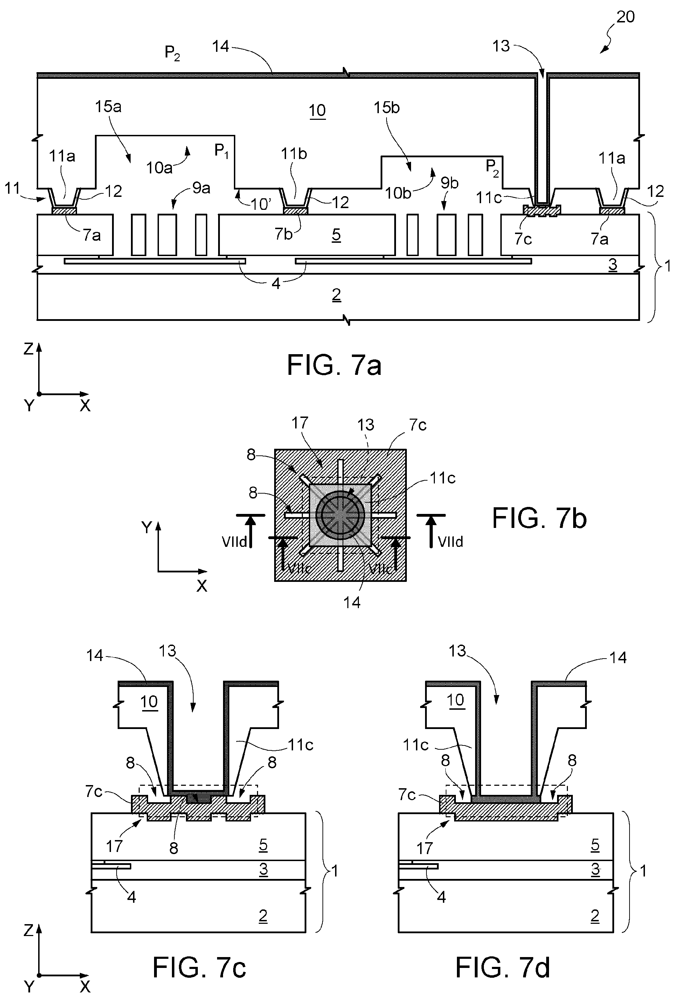

Subsequently, with reference to Figures 7a-7d, the composite wafer 20 is entirely coated with a sealing layer 14 and, at the same time, the access hole 13 closes with respect to the external environment. In detail, the sealing layer 14 penetrates the access hole 13 at least up to the stop pad 7c, filling the portions of the channels 8 in the exchange region 17 left exposed by the access hole 13 (see the details of Figures 7c and 7d). The deposition of the sealing layer 14 is performed in the atmosphere at the second pressure P₂ and hermetically closes the second chamber 15b with respect to the environment external to the composite wafer 20. The second chamber 15b is therefore sealed at and maintains the second pressure P₂; consequently, the second sensor of the final device operates at the second pressure P2.

The sealing layer 14 is for example chosen from among the following materials and/or compounds of materials: TEOS (tetraethyl orthosilicate), SiN (silicon nitride), SiON (silicon oxynitride), TEOS + SiN, TEOS + SiON, TEOS + SiN + AlCu (aluminum-copper alloys). The choice may depend for example on the degree of sealing and mechanical integrity required. The sealing process by the sealing layer 14 may be performed using for example PECVD (Plasma-Enhanced Chemical Vapor Deposition) techniques, or PVD (Physical Vapor Deposition) techniques, at the second pressure P₂.

Finally, with reference to Figure 8, the composite wafer 20 undergoes final grinding processes, which lead for example to a thinning of the cap wafer 10, wet cleaning and drying processes (for example by vacuum prime-vacuum drying). External contacts and pads useful for driving and extracting signals are then defined; more generally, the operations necessary for the definition of the final device comprising the first and the second sensors (and having the structure shown in Figure 8) are completed, among which the dicing processes of the composite wafer 20. The remaining recess in the cap wafer 10 in a position corresponding to the access hole 13 is filled during subsequent molding processes of the final device.

The manufacturing process of the present invention allows the operating conditions of the chambers that accommodate the different microelectromechanical sensors integrated into the final device to be independently adjusted. In particular, by means of the process presented the best pressure and/or operating gaseous composition may be selected - in consecutive steps - in a flexible and accurate manner for each sensor, eliminating issues relating to cross-talk between different chambers. In this manner, devices manufactured by means of the present process have performance characteristics with lower trend to drift over time and are ultimately more reliable.

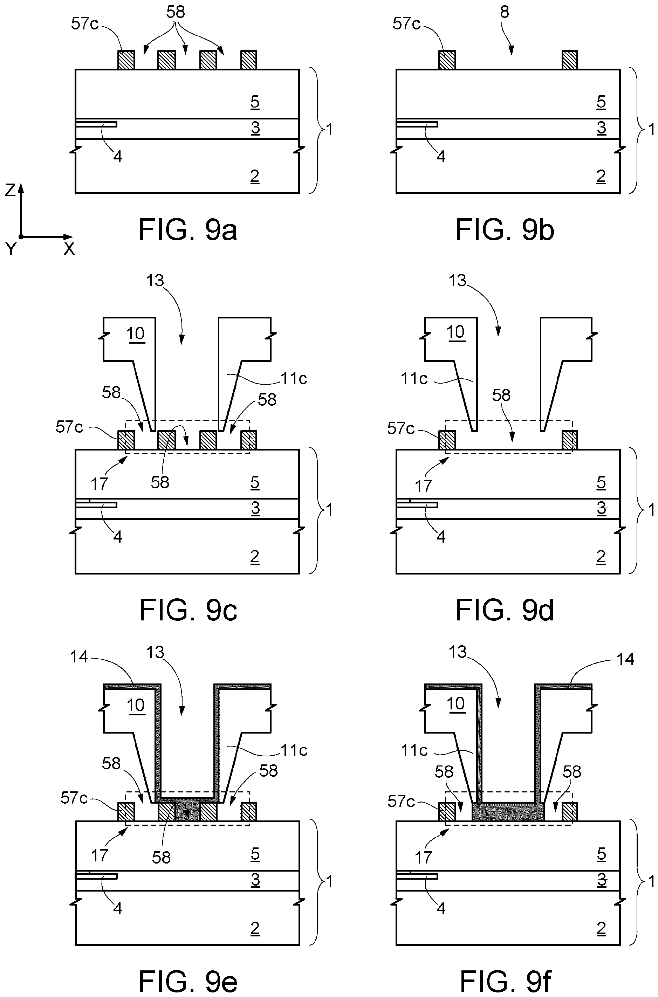

Figures 9a-9f illustrate details of a different embodiment of the manufacturing process subject-matter of the present invention. Elements of Figures 9a-9f which correspond to elements of Figures 1-8 are indicated with the same reference numerals and the differences are shown with respect to the embodiment previously described.

With reference to Figures 9a and 9b (which show details of sections of the wafer 1 similar with respect to those of Figures 3c and 3d), the stop layer 7 is deposited on the structural layer 5 (without having first defined grooves) and is patterned to define the frame portion 7a, the separation portion 7b (not shown here) and a stop pad 57c. In this step, channels 58 are opened in an internal portion of the stop pad 57c. In particular, the stop pad 57c is similar to the stop pad 7c in shape and positioning in the wafer 1 (see Figure 3b) and the channels 58 of the stop pad 57c are organized in a pattern similar to that of the grooves 6 of the structural layer 5 of the embodiment of Figure 2a.

The channels 58 of the stop pad 57c may be formed at the same time as the patterning of the stop layer 7 or by a dedicated anisotropic etching and traverse entirely the stop pad 57c up to the structural layer 5. In other words, the channels 58 leave exposed portions of the structural layer 5 according to the predetermined pattern. The exchange region 17 comprises the channels 58 of the stop pad 57c overlaid by the third contact element 11c.

The cap wafer 10 is bonded to the wafer 1 according to what has already been previously described and the first chamber 15a is sealed at the same time at the first pressure P₁. The access hole 13 is then provided in the cap wafer 10 (Figures 9c and 9d), in a position corresponding to the stop pad 57c, leaving exposed portions of the channels 58 (i.e. corresponding portions of the structural layer 5) in the exchange region 17, similarly to what has been shown in Figure 6b. The channels 58 therefore form, like the channels 8 of the stop pad 7c, fluidic passages that put the second chamber 15b in communication with the environment external to the composite wafer 20, through the exchange region 17 and the access hole 13.

The composite wafer 20 is then placed in the atmosphere at the second pressure P₂ and the sealing layer 14 is deposited on the cap wafer 10. Figures 9e and 9f (which are details of sections of the wafer 1 similar with respect to those of Figures 7c and 7d) show in detail the sealing layer 14 at the stop pad 57c. The sealing layer 14, in the present embodiment, comes into contact with the stop pad 57c as well as with the structural layer 5, filling the portions of the channels 58 in the exchange region 17 left exposed by the access hole 13. The second chamber 15b is thus hermetically closed - at the second pressure P₂ - with respect to the environment external to the composite wafer 20.

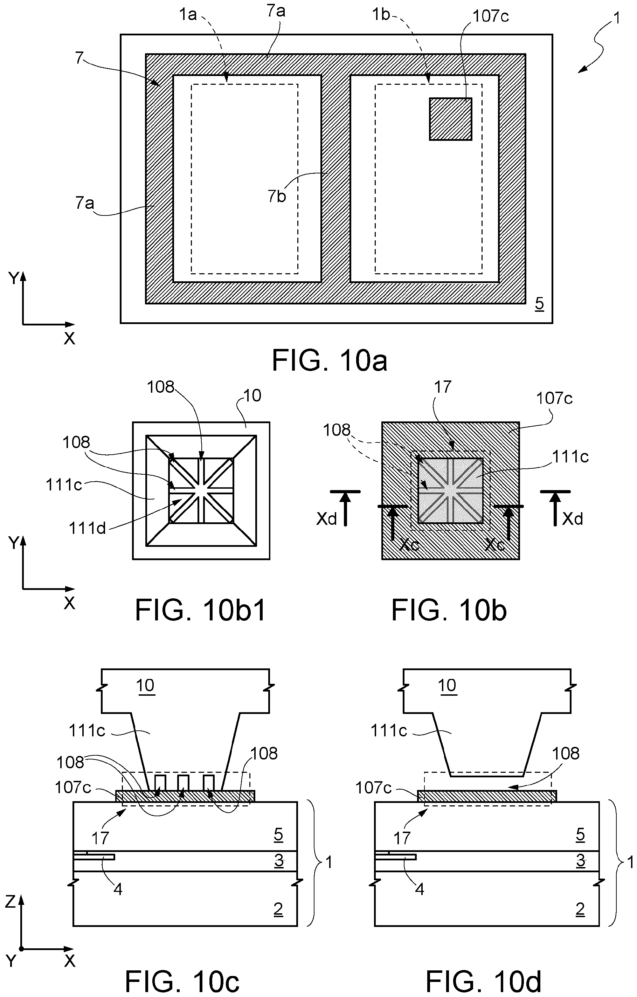

Figures 10a-10h illustrate details of another embodiment of the manufacturing process subject-matter of the present invention. Elements of Figures 10a-10h that correspond to elements of Figures 1-8 are indicated with the same reference numerals and the differences are shown with respect to the embodiments previously described.

With reference to Figures 10a and 10b, the structural layer 5 of the present embodiment is free of grooves. Furthermore, the stop layer 7 comprises a stop pad 107c, similar to the stop pad 7c in shape and positioning in the wafer 1 (see Figure 3b), also free of grooves. The cap wafer 10 comprises in the present embodiment the first and the second contact elements 11a, 11b, and a third contact element 111c similar in shape and positioning in the cap wafer 10 to the third contact element 11c.

Before bonding the cap wafer 10 to the semiconductor wafer 1, surface channels 108 are formed at one end of the third contact element 111c (see also the two distinct sections of Figures 10c and 10d), which extend from side to side of a contact face 111d of the third contact element 111c parallel to the XY plane (see Figure 10b1) and are for example organized in a pattern similar to those of the preceding embodiments.

The cap wafer 10 is bonded to the wafer 1 according to what has already been previously described and the first chamber 15a is sealed at the same time at the first pressure P₁. The third contact element 111c rests on the stop pad 107c, which is wider than the contact face 111d and delimits the channels 108 on one side (parallel to the XY plane). The exchange region 17 comprises the channels 108 of the third contact element 111c.

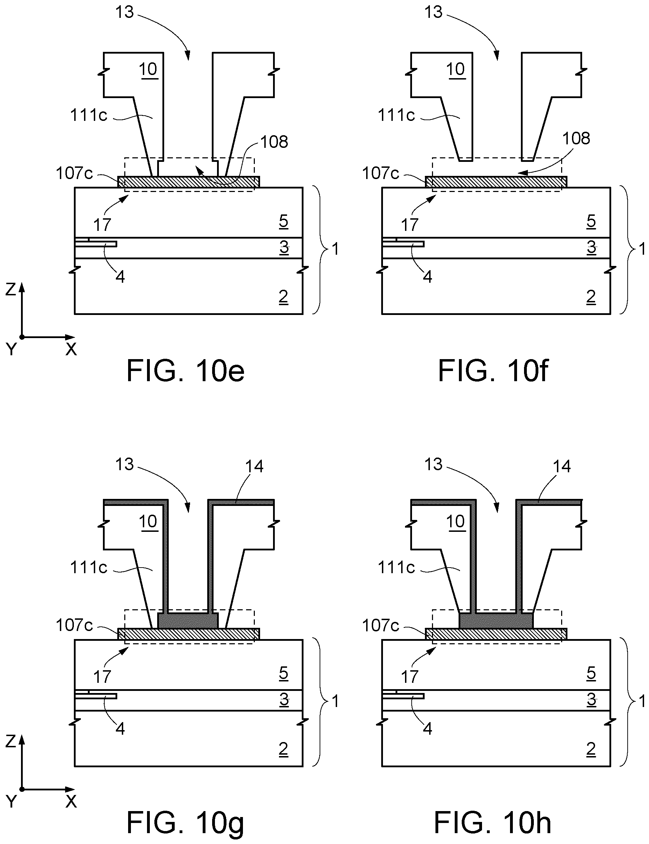

The access hole 13 is then provided in the cap wafer 10 (Figures 10e and 10f), in a position corresponding to the stop pad 107c, leaving exposed a portion of the stop pad 107c in the exchange region 17. Residual portions of the channels 108 form therefore fluidic passages that put the second chamber 15b in communication with the environment external to the composite wafer 20, through the exchange region 17 and the access hole 13.

The composite wafer 20 is then placed in the atmosphere at the second pressure P₂ and the sealing layer 14 is deposited on the cap wafer 10. In Figures 10g and 10h the sealing layer 14 is shown in detail at the stop pad 107c. The sealing layer 14, in the present embodiment, comes into contact with the portion left exposed of the stop pad 107c, covering it, with a thickness such as to reach the third contact element 111c; the sealing layer 14 possibly also fills at least part of the residual portions of the channels 108 of the third contact element 111c. The second chamber 15b is thus hermetically closed - at the second pressure P₂ - with respect to the environment external to the composite wafer 20.

Finally, it is clear that modifications and variations may be made to what has been described and illustrated herein without thereby departing from the scope of the present invention, as defined in the attached claims.

For example, the pattern of channels, obtained in the semiconductor wafer or in the cap wafer, may have different shapes from that previously illustrated while still ensuring fluidic coupling towards the outside for one of the device chambers. Furthermore, although a unique group of channels has been presented in the preceding description, it is understood that the semiconductor wafer or the cap wafer may be processed in order to comprise multiple groups of channels, which may also differ from each other in pattern depending on the desired sealing performance and/or depending on the number of chambers of the device. In an embodiment not shown, the fluidic passages may be formed by structures that comprise mixed characteristics of the solutions previously described: for example, the fluidic passages may comprise channels defined on both the semiconductor wafer (for example, on the stop pad) and on the cap wafer (on the third contact element).

As to the contact elements of the cap wafer, it is understood that they may have, in cross-sections, shapes different from the one presented. For example, the third contact element may have the shape of a cylinder three-dimensionally.

In the bonding process of the cap wafer to the semiconductor wafer, wafer-to-wafer bonding techniques may be used different from what has been shown. In a variant not illustrated, for example, the cap wafer comprises only the third contact element and the bonding to the semiconductor wafer (and the separation between the chambers) is performed by glass frit bonding (a bonding technique that uses a glassy intermediate layer).

The first and the second pressures at which respectively the first and the second chambers of the device are closed may be in a different relationship from what has been described. In particular, the first pressure may be lower than the second pressure.

Finally, the process according to the present invention may be extended, in addition to inertial sensors, to the manufacture of devices that require a high vacuum level (pressures of the order of microbar units) during the packaging steps, such as for example bolometers and geophones.

## Claims

1. A process for manufacturing microelectromechanical devices comprising:
on a first semiconductor wafer (1) comprising a substrate (2) of semiconductor material forming a dielectric layer (3), a structural layer (5) and a stop layer (7) on the structural layer (5);
defining a stop pad (7c; 57c; 107c) from the stop layer (7);
forming a first microelectromechanical structure (9a) and a second microelectromechanical structure (9b) in the structural layer (5);
forming a contact element (11c; 111c) protruding on a face (10') of a second semiconductor wafer (10), selectively etchable with respect to the stop layer (7);
sealing, at a first pressure (P₁), the first microelectromechanical structure (9a) in a first chamber (15a) and the second microelectromechanical structure (9b) and the stop pad (7c; 57c; 107c) in a second chamber (15b);
fluidically coupling the second chamber (15b) to an external environment through the second semiconductor wafer (10); and
sealing the second chamber (15b) at a second pressure (P₂) different from the first pressure (P₁);
wherein sealing the first microelectromechanical structure (9a) and the second microelectromechanical structure (9b) comprises bonding the second semiconductor wafer (10) to the first semiconductor wafer (1) so that the contact element (11c; 111c) rests on the stop pad (7c; 57c; 107c);
wherein fluidically coupling comprises defining fluidic passages (8; 58; 108) at an interface between the contact element (11c; 111c) and the stop pad (7c; 57c; 107c) and opening an access hole (13) to the second chamber (15b) through the second semiconductor wafer (10) up to the stop pad (7c; 57c; 107c), in communication with the fluidic passages (8; 58; 108).

2. The manufacturing process according to claim 1, wherein sealing the first microelectromechanical structure (9a) and the second microelectromechanical structure (9b) comprises bonding the second semiconductor wafer (10) to the first semiconductor wafer (1) in an atmosphere at the first pressure (P₁).

3. The manufacturing process according to any of the preceding claims, wherein defining the fluidic passages (8) comprises:
defining grooves (6) in the structural layer (5), in a position corresponding to the stop pad (7c); and
depositing the stop layer (7) on the structural layer (5) in a conformal manner, with a thickness such that in the stop pad (7c) the fluidic passages (8) correspond in shape and position to respective grooves (6) of the structural layer (5).

4. The manufacturing process according to any of the preceding claims, wherein defining the fluidic passages (58) comprises opening channels (58) in the stop pad (7c) after forming the stop layer (7).

5. The manufacturing process according to any of the preceding claims, wherein ends of the fluidic passages (8; 58) protrude laterally on the stop pad (7c; 57c) with respect to the contact element (11c).

6. The manufacturing process according to any of the preceding claims, wherein defining the fluidic passages (108) comprises defining surface channels (108) at one end of the contact element (111c) of the second semiconductor wafer (10).

7. The manufacturing process according to any of the preceding claims wherein opening the access hole (13) comprises etching the second semiconductor wafer (10) and stopping the etching on the stop pad (7c; 57c; 107c), and
wherein the stop layer (7) comprises one or more materials chosen from among: aluminum; titanium-tungsten compounds.

8. The manufacturing process according to any of the preceding claims, wherein the access hole (13) leaves portions of the fluidic passages (8; 58; 108) exposed.

9. The manufacturing process according to any of the preceding claims, wherein sealing the first chamber (15a) and the second chamber (15b) at the first pressure (P₁) comprises:
defining from the stop layer (7) on the first semiconductor wafer (1) a frame portion (7a), delimiting the first microelectromechanical structure (9a) and the second microelectromechanical structure (9b), and a separation portion (7b) between the first microelectromechanical structure (9a) and the second microelectromechanical structure (9b);
defining on the second semiconductor wafer (10), further contact elements (11a, 11b), in positions corresponding to the frame portion (7a) and the separation portion (7b) of the stop layer (7);
coating the further contact elements (11a, 11b) with a bonding layer (12); and
bonding the second semiconductor wafer (10) to the first semiconductor wafer (1) by a thermal bonding process.

10. The manufacturing process according to the preceding claim, wherein the bonding layer (12) comprises one or more materials chosen from among: germanium-aluminum compounds; gold-germanium compounds; gold-indium compounds; gold-silicon compounds; gold-tin compounds; copper-tin compounds.

11. The manufacturing process according to any of the preceding claims, wherein sealing the second chamber (15b) at the second pressure (P₂) comprises closing the fluidic passages (8; 58; 108).

12. The manufacturing process according to any of the preceding claims, wherein sealing the second chamber (15b) at the second pressure (P₂) comprises forming a sealing layer (14) on the second semiconductor wafer (10) and in the access hole (13).

13. The manufacturing process according to the preceding claim, wherein the sealing layer (14) closes the fluidic passages (8; 58; 108) inside the access hole (13).

14. The manufacturing process according to claim 12 or 13, wherein the sealing layer (14) comprises one or more materials chosen from among: tetraethyl orthosilicate; silicon nitride; silicon oxynitride; tetraethyl orthosilicate and silicon nitride compounds; tetraethyl orthosilicate and silicon oxynitride compounds; tetraethyl orthosilicate, silicon nitride and aluminum-copper alloys compounds.

15. A microelectromechanical device comprising:
a substrate (2) of semiconductor material;
a dielectric layer (3) on the substrate (2);
a structural layer (5) of semiconductor material on the dielectric layer (3);
a stop layer (7) on the structural layer (5);
in the structural layer (5), a first microelectromechanical structure (9a) sealed in a first chamber (15a) at a first pressure (P₁) and a second microelectromechanical structure (9b) sealed in a second chamber (15b) at a second pressure (P₂);
a stop pad (7c; 57c; 107c) defined from the stop layer (7) in the second chamber (15b);
a cap (10), selectively etchable with respect to the stop pad (7c; 57c; 107c) and delimiting the first chamber (15a) and the second chamber (15b), wherein the cap (10) comprises a protruding contact element (11c; 111c) resting on the stop pad (7c; 57c; 107c);
an access hole (13) extending through the cap (10) up to the stop pad (7c; 57c; 107c);
fluidic passages (8; 58; 108) between the access hole (13) and the second chamber (15b) at an interface between the contact element (11c; 111c) and the stop pad (7c; 57c; 107c); and
a sealing layer (14) which closes the fluidic passages (8; 58; 108) and fluidically insulates the second chamber (15b) from the access hole (13).

16. The device according to claim 15, wherein the fluidic passages comprise channels (8; 58) in the stop pad (7c; 57c).

17. The device according to claim 15, wherein the fluidic passages comprise surface channels (108) at one end of the contact element (111c) resting on the stop pad (107c).
